# EUROPEAN PATENT APPLICATION

(11) **EP 4 503 339 A1**
(43) Date of publication of application: **05.02.2025**
(21) Application number: 24185542.8
(22) Date of filing: 28.06.2024
(51) Int. Cl.: H01R 12/58, H05K 3/30

(54) **COMPLIANT PIN**

(30) Priority: 02.08.2023 IN 202311051911
(71) Applicant: Honeywell International Inc., Charlotte, NC 28202 (US)
(72) Inventor: R, Gangaraju, Charlotte, 28202 (US); OLSON, Thomas, Charlotte, 28202 (US); M, Jithun, Charlotte, 28202 (US)
(74) Representative: Haseltine Lake Kempner LLP

(57) **Abstract**

A compliant pin is provided. The compliant pin includes, but not limited to: a main section; and a first insertion section on a first end of the main section and configured to be inserted into a through-hole of a printed circuit board (PCB) to provide an electrical connection between the compliant pin and the PCB. The first insertion section includes, but not limited to: a contact portion; a first spring positioned, where the first spring is configured to be compressed during an insertion process and recover elasticity in an instance in which the first spring passes the through-hole of the PCB; and a second spring positioned, where in the instance in which the first spring passes the through-hole of the PCB, the second spring is configured to stop the first insertion section, and the first spring and the second spring constrain movement of the PCB.

## Description

### FIELD OF THE INVENTION

Exemplary embodiments of the present disclosure relate generally to a compliant pin, and more particularly, in some examples, to a compliant pin for connecting with a printed circuit board (PCB).

### BACKGROUND

Applicant has identified many technical challenges and difficulties associated with connecting with a printed circuit board (PCB) with a compliant pin. Through applied effort, ingenuity, and innovation, Applicant has solved problems relating to improving a location feature of the compliant pin by developing solutions embodied in the present disclosure, which are described in detail below.

### BRIEF SUMMARY

Various embodiments described herein relate to a compliant pin for connecting with a printed circuit board (PCB).

In accordance with various embodiments of the present disclosure, compliant pin is provided. The compliant pin includes, but not limited to: a main section; and a first insertion section on a first end of the main section and configured to be inserted into a through-hole of a printed circuit board (PCB) to provide an electrical connection between the compliant pin and the PCB. The first insertion section includes, but not limited to: a contact portion; a first spring positioned on a first end of the contact portion, where the first spring is configured to be compressed during an insertion process and recover elasticity in an instance in which the first spring passes the through-hole of the PCB; and a second spring positioned on a second end of the contact portion, where in the instance in which the first spring passes the through-hole of the PCB, the second spring is configured to stop the first insertion section, and the first spring and the second spring constrain movement of the PCB.

In some embodiments, the first insertion section has a needle eye structure.

In some embodiments, the second spring is configured to be in contact with a first surface of the PCB and the first spring is configured to be in contact with a second surface of the PCB to constrain the movement of the PCB in the instance in which the first spring passes the through-hole of the PCB.

In some embodiments, the contact portion comprises a middle portion that protrudes away from a longitudinal axis of the first insertion section.

In some embodiments, the middle portion is configured to be compressed by the through-hole of the PCB in the instance in which the first insertion section passes the through-hole of the PCB.

In some embodiments, the through-hole of the PCB comprises a conductive plating sidewall, and the middle portion is configured to be compressed by the conductive plating sidewall to provide the electrical connection between the compliant pin and the PCB.

In some embodiments, the conductive plating sidewall extends between a first surface of the PCB and a second surface of the PCB.

In some embodiments, the first insertion section has a cylindrical structure.

In some embodiments, the contact portion comprises a plurality of contact splits distributed around a longitudinal axis of the first insertion section.

In some embodiments, the plurality of contact splits are uniformly distributed around the longitudinal axis of the first insertion section.

In some embodiments, the contact portion comprises four contact splits uniformly distributed around the longitudinal axis of the first insertion section.

In some embodiments, each of the plurality of contact splits comprises a middle portion configured to be compressed by the through-hole of the PCB in the instance in which the first insertion section passes the through-hole of the PCB.

In some embodiments, the through-hole of the PCB comprises a conductive plating sidewall, and the middle portion is configured to be compressed by the conductive plating sidewall to provide the electrical connection between the compliant pin and the PCB.

In some embodiments, the conductive plating sidewall extends between a first surface of the PCB and a second surface of the PCB.

In some embodiments, the compliant pin is formed by a stamping process.

In some embodiments, the first spring and the second spring are made of a same material, where the same material comprises at least one of epoxy, plastic, and metal.

In some embodiments, the first spring and the second spring are on opposite sides of a longitudinal axis of the first insertion section.

In some embodiments, the PCB comprises at least one of epoxy, ceramic, alumina, and liquid crystalline polymers (LCPs).

In some embodiments, the compliant pin further includes a second insertion section on a second end of the main section and configured to be inserted into a through-hole of another PCB to provide an electrical connection between the compliant pin and the another PCB, where the first insertion section and the second insertion section have a same structure.

In some embodiments, the PCB is electrically connected with the another PCB through the compliant pin.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 illustrates a perspective view of an example compliant pin, in accordance with various embodiments of the present disclosure;
FIG. 2A and FIG. 2B illustrate a cross-section view and an isometric view of an example compliant pin inserted into an example printed circuit board (PCB), in accordance with various embodiments of the present disclosure;
FIG. 3 illustrates a perspective view of an example compliant pin, in accordance with various embodiments of the present disclosure;
FIG. 4A and FIG. 4B illustrate a cross-section view and an isometric view of an example compliant pin inserted into an example PCB, in accordance with various embodiments of the present disclosure; and
FIG. 5A and FIG. 5B illustrate a perspective view and a cross-section view of example compliant pins inserted into example PCBs, in accordance with various embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as "comprises", "includes", and "having" should be understood to provide support for narrower terms such as "consisting of", "consisting essentially of", and "comprised substantially of".

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

The terms "electronically coupled" or "in electronic communication with" in the present disclosure may refer to two or more electrical elements (for example, but not limited to, an example processing circuitry, communication module, input/output module, memory) and/or electric circuit(s) being connected through wired means (for example, but not limited to, conductive wires or traces) and/or wireless means (for example, but not limited to, wireless network, electromagnetic field), such that electronic indications, signal or the like data and/or information (for example, electronic indications, signals) may be transmitted to and/or received from the electrical elements and/or electric circuit(s) that are electronically coupled.

The term "compliant pin" in the present disclosure may refer to a pin that can be configured to be inserted into a through-hole of a printed circuit board (PCB) such that a contact between the pin and the through-hole of the PCB may result in an electrical connection between the pin and the PCB. For example, the contact between the pin and the through-hole of the PCB may be realized by a contact section, such as a needle eye section, a cylindrical section, and/or the like. In some examples, the compliant pin may be used as a terminal for an electrical device. In some examples, the compliant pin may provide mechanical support for the PCB and/or an electrical device. In some examples, the compliant pin may be also referred as a press-fit pin.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

Various example embodiments address exemplary technical problems associated with compliant pins for connecting with printed circuit boards (PCBs). As understood by those of skill in the field to which the present disclosure pertains, for example, movement between the compliant pins and the PCBs may cause intermittence in an electrical connection between the compliant pins and the PCBs. For example, vibrations and/or mechanical shocks may cause the movement between the compliant pins and the PCBs in an axial direction, which may lead to a wear out in the PCBs. As a result, the electrical connection between the compliant pins and the PCBs may become week or intermittent. Therefore, there's a need to constrain the movement between the compliant pins and the PCBs.

To address at least these exemplary problems as well as others, example compliant pins described herein improve, in some examples, the electrical connection to the PCBs by providing spring features to limit the movement of the PCBs. For example, an example compliant pin may include a first spring and a second spring positioned on two ends of a contact portion of the example compliant pin. In some examples, the first spring and the second spring may be configured to constrain the movement of the PCB in an instance in which the first spring passes a through-hole of the PCB. As a result, the movement between the PCB and the example compliant pin is reduced, which, in some examples, may therefore reduce the wear out in the PCB and improve the electrical connection between the PCB and example compliant pin.

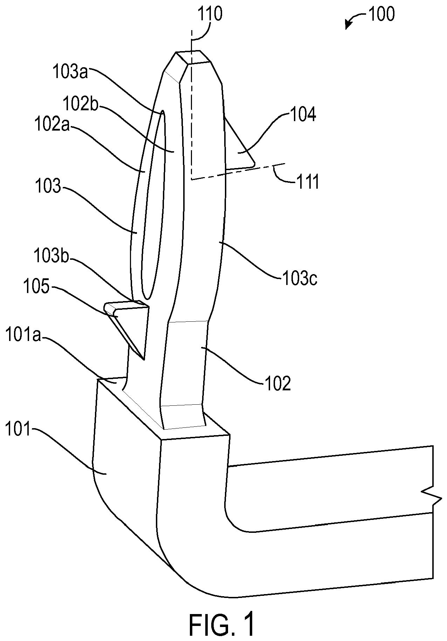

Referring now to FIG. 1, an example diagram illustrating a perspective view of an example compliant pin 100 in accordance with some example embodiments described herein is provided. As illustrated in FIG. 1, the example compliant pin 100 may comprise a main section 101 and an insertion section 102 positioned at a first end 101a of the main section 101. For example, the insertion section 102 may be attached to the main section 101.

In some embodiments, the insertion section 102 may comprise a contact portion 103. In some examples, the insertion section 102 may be configured to carry an electrical signal to and/or from a through-hole of a PCB (not shown).

In some examples, the insertion section 102 may have a needle eye structure. For example, the needle eye structure may comprise two opposing arms (e.g. 102a and 102b). In some examples, an outward force may be applied in an instance in which the two opposing arms are compressed inwards.

In some examples, the contact portion 103 may have a middle portion 103c that protrudes away from a longitudinal axis 110 of the insertion section 102. For example, the middle portion 103c may be compressed by a sidewall of the through-hole of the PCB in an instance in which the insertion section 102 is inserted into the through-hole of the PCB, such that the contact portion 103 and the sidewall of the through-hole of the PCB may be electrically connected. In some examples, the two opposing arms (e.g. 102a and 102b) may be compressed by the sidewall of the through-hole of the PCB in the instance in which the insertion section 102 is inserted into the through-hole of the PCB, such that the contact portion 103 and the sidewall of the through-hole of the PCB may be electrically connected.

In some embodiments, the insertion section 102 may further comprise a first spring 104 and a second spring 105. For example, the first spring 104 may be positioned on a first end 103a of the contact portion 103 along the longitudinal axis 110 of the insertion section 102. For example, the second spring 105 may be positioned on a second end 103b of the contact portion 103 along the longitudinal axis 110 of the insertion section 102. In some examples, the first spring 104 and the second spring 105 may be positioned on opposite sides of the longitudinal axis 110 of the insertion section 102.

In some examples, the first spring 104 and the second spring 105 may be formed by a stamping process. In some examples, the first spring 104, the second spring 105, and the contact portion 103 may be made of a same material. In some examples, the first spring 104 and the second spring 105 may be the made of a same material that is different from the contact portion 103. For example, the first spring 104 and the second spring 105 may be made of a material of epoxy, ceramic, plastic, metal, combinations thereof, and/or the like.

In some examples, each of the first spring 104 and the second spring 105 may be a protrusion from a surface of the contact portion 103 in an axial direction 111 of the insertion section 102. For example, the axial direction 111 of the insertion section 102 may be perpendicular to the longitudinal axis 110 of the insertion section 102.

In some examples, the first spring 104 and the second spring 105 may be 180° apart from each other around the longitudinal axis 110 of the insertion section 102.

In some embodiments, as the insertion of the example compliant pin 100 into the through-hole of the PCB starts along a direction of the longitudinal axis 110 of the insertion section 102, the first spring 104 may be compressed by the sidewall of the through-hole during an insertion process. In some examples, as the insertion of the example compliant pin 100 into the through-hole of the PCB further proceeds, the first spring 104 may recover elasticity after passing through the through-hole of the PCB, such that the first spring 104 and the second spring 105 may constrain the movement of the PCB.

In some examples, the example compliant pin 100 may be configured to provide a power supply for the PCB and/or a sensor device (not shown). In some examples, the example compliant pin 100 may be configured to provide a signal channel for the PCB and/or the sensor device.

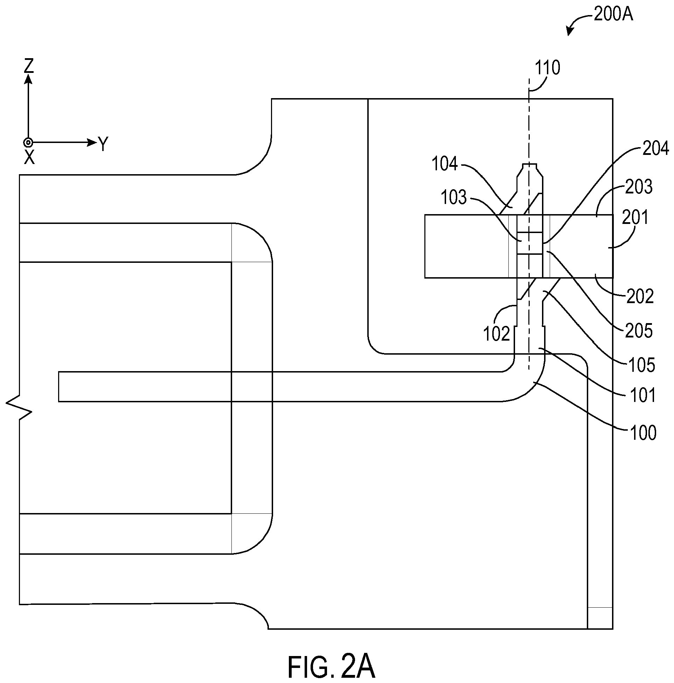

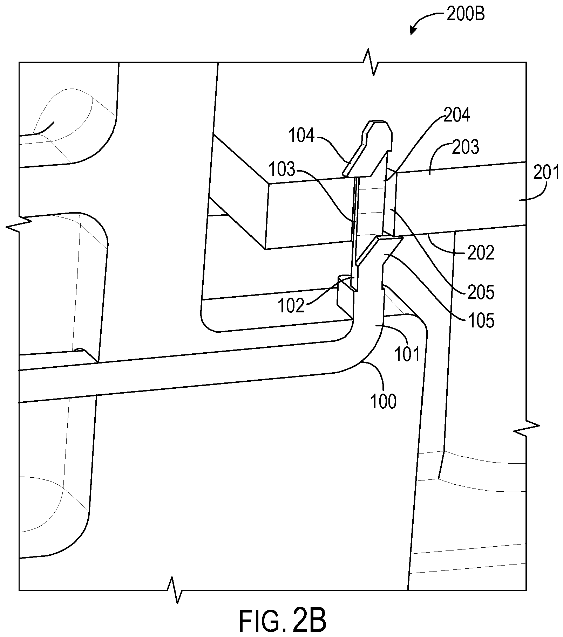

Referring now to FIG. 2A and FIG. 2B, example diagrams illustrating a cross-section view 200A and an isometric view 200B of an example compliant pin 100 inserted into an example PCB 201 in accordance with some example embodiments described herein is provided. For example, as shown in FIG. 2A and FIG. 2B, the example compliant pin 100 may be inserted into the example PCB 201 to provide an electrical connection between the example compliant pin 100 and the example PCB 201. In some examples, components of the example compliant pin 100 described herein in FIG. 2A and FIG. 2B may correspond to the components of the example compliant pin 100 as described in FIG. 1. In some examples, components of the example PCB 201 described herein in FIG. 2B may correspond to the components of the example PCB 201 as described in FIG. 2A.

In some embodiments, the example PCB 201 may comprise a through-hole 204. In some examples, the through-hole 204 may have a sidewall 205 that extends between a first surface 202 of the example PCB 201 and a second surface 203 of the example PCB 201. In some examples, the sidewall 205 of the through-hole 204 may be a conductive plating sidewall that extends and/or connects the first surface 202 of the example PCB 201 and the second surface 203 of the example PCB 201. In some examples, the through-hole 204 may be a plating through hole (PTH). In some examples, the through-hole 204 may be a non-plating through hole (NPTH).

In some examples, the sidewall 205 of the through-hole 204 may comprise at least one conducting material that is configured to carry an electrical signal to and/or from the compliant pin 100 to the sidewall 205 of the through-hole 204. For example, the at least one conducting material may be copper, aluminum, gold, silver, combinations thereof, and/or the like.

In some examples, the example PCB 201 may be or comprise epoxy, ceramic, alumina, liquid crystalline polymers (LCPs), combinations thereof, and/or the like.

In some embodiments, as the insertion of the example compliant pin 100 into the through-hole 204 of the example PCB 201 starts along a direction of the longitudinal axis 110 of the insertion section 102 (e.g., a z-direction), the first spring 104 may be compressed by the sidewall 205 of the through-hole 204 of the PCB 201 during the insertion process.

In some embodiments, as the insertion of the example compliant pin 100 into the through-hole 204 of the example PCB 201 further proceeds, the first spring 104 may pass through the through-hole 204 as shown in FIG. 2A.

In some examples, the second spring 105 may stop further insertion of the example compliant pin 100 into the through-hole 204 of the example PCB 201 in an instance in which the second spring 105 is in contact with the first surface 202 of the example PCB 201. In some examples, the second spring 105 may be configured to determine an insertion depth of the example compliant pin 100.

In some embodiments, the first spring 104 may recover elasticity in an instance in which the first spring 104 passes through the through-hole 204, and thus the first spring 104 may be in contact with the second surface 203 of the example PCB 201.

In some examples, the example PCB 201 is configured to rest between the first spring 104 and the second spring 105, such that movement of the example PCB 201 in the direction of the longitudinal axis 110 of the insertion section 102 (e.g., the z-direction) is constrained.

In some embodiments, the insertion section 102 may have a needle eye structure (not shown). For example, the needle eye structure may be compressed in an x-direction by the sidewall 205 of the through-hole 204 of the example PCB 201 in an instance in which the insertion section 102 is inserted into the through-hole 204 of the example PCB 201, such that the contact portion 103 and the sidewall 205 of the through-hole 204 of the example PCB 201the example PCB 201 may be electrically connected.

In some examples, an axial holding force between the contact portion 103 and the sidewall 205 of the through-hole 204 of the example PCB 201 may depends on a diameter of the through-hole 204 of the example PCB 201 and a size of the contact portion 103.

In some embodiments, example compliant pin 100 may be used to connect the example PCB 201 with a sensor device (not shown), such that a flatness of PCB may be maintained.

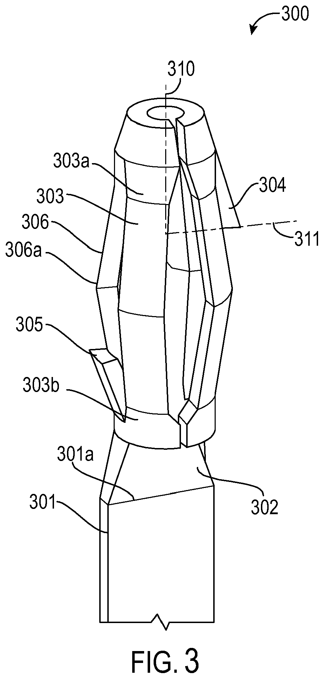

Referring now to FIG. 3, an example diagram illustrating a perspective view of an example compliant pin 300 in accordance with some example embodiments described herein is provided. As illustrated in FIG. 3, the example compliant pin 300 may comprise a main section 301 and an insertion section 302 positioned at a first end 301a of the main section 301. For example, the insertion section 302 may be attached to the main section 301.

In some embodiments, the insertion section 302 may comprise a contact portion 303. In some examples, the insertion section 302 may be configured to carry an electrical signal to and/or from a through-hole of a PCB (not shown).

In some examples, the contact portion 303 may have a cylindrical structure. In some examples, the contact portion 303 may comprise a plurality of contact splits 306 uniformly distributed around a longitudinal axis 310 of the insertion section 302. For example, the contact portion 303 may comprise four contact splits 306 uniformly distributed around the longitudinal axis 310 of the insertion section 302.

In some examples, each of the plurality of contact splits 306 may have a middle portion 306a that protrudes away from a longitudinal axis 310 of the insertion section 302. For example, the middle portion 306a may be compressed by a sidewall of the through-hole of the PCB in an instance in which the insertion section 302 is inserted into the through-hole of the PCB, such that the contact portion 303 and the sidewall of the through-hole of the PCB may be electrically connected.

In some embodiments, the insertion section 302 may further comprise a first spring 304 and a second spring 305. For example, the first spring 304 may be positioned on a first end 303a of the contact portion 303 along the longitudinal axis 310 of the insertion section 302. For example, the second spring 305 may be positioned on a second end 303b of the contact portion 303 along the longitudinal axis 310 of the insertion section 302. In some examples, the first spring 304 and the second spring 305 may be positioned on opposite sides of the longitudinal axis 310 of the insertion section 302.

In some examples, each of the first spring 304 and the second spring 305 may be a protrusion from a surface of the contact portion 303 in an axial direction 311 of the insertion section 302. For example, the axial direction 311 of the insertion section 302 may be perpendicular to the longitudinal axis 310 of the insertion section 302.

In some examples, the first spring 304 and the second spring 305 may be 180° apart from each other around the longitudinal axis 310 of the insertion section 302.

In some examples, the first spring 304 and the second spring 305 may be formed by a stamping process. In some examples, the first spring 304, the second spring 305, and the contact portion 303 may be made of a same material. In some examples, the first spring 304 and the second spring 305 may be the made of a same material that is different from the contact portion 303. For example, the first spring 304 and the second spring 305 may be made of a material of epoxy, ceramic, plastic, metal, combinations thereof, and/or the like.

In some embodiments, as the insertion of the example compliant pin 300 into the through-hole of the PCB starts along a direction of the longitudinal axis 310 of the insertion section 302, the first spring 304 may be compressed by the sidewall of the through-hole during the insertion process. In some examples, as the insertion of the example compliant pin 300 into the through-hole of the PCB further proceeds, the first spring 304 may recover elasticity after passing through the through-hole, such that the first spring 304 and the second spring 308 may constrain the movement of the PCB.

In some examples, the example compliant pin 300 may be configured to provide a power supply for the PCB and/or a sensor device (not shown). In some examples, the example compliant pin 300 may be configured to provide a signal channel for the PCB and/or the sensor device.

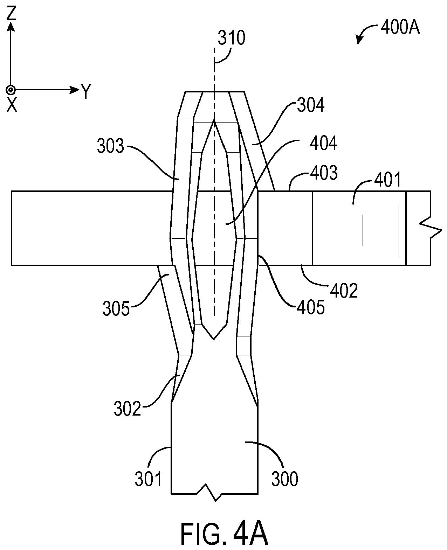

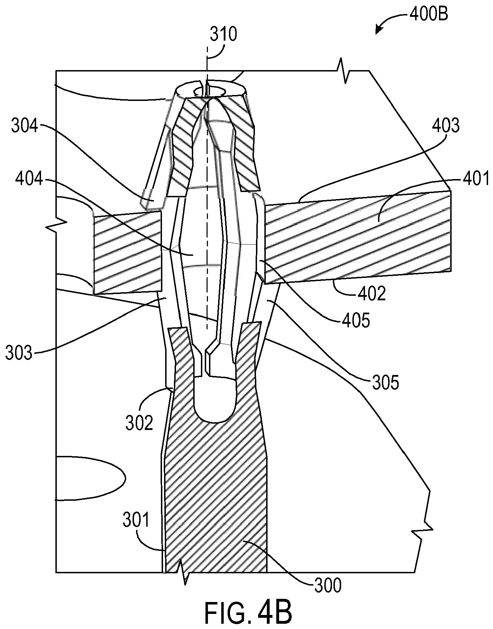

Referring now to FIG. 4A and FIG. 4B, example diagrams illustrating a cross-section view 400A and an isometric view 400B of an example compliant pin 300 inserted into an example PCB 401 in accordance with some example embodiments described herein is provided. For example, as shown in FIG. 4A and FIG. 4B, the example compliant pin 300 may be inserted into the example PCB 401 to provide an electrical connection between the example compliant pin 300 and the example PCB 401. In some examples, components of the example compliant pin 300 described herein in FIG. 4A and FIG. 4B may correspond to the components of the example compliant pin 300 as described in FIG. 1. In some examples, components of the example PCB 401 described herein in FIG. 4B may correspond to the components of the example PCB 401 as described in FIG. 4A.

In some embodiments, as shown in FIG. 4A and FIG. 4B, the example PCB 401 may comprise a through-hole 404. In some examples, the through-hole 404 may have a sidewall 405 that extends between a first surface 402 of the example PCB 401 and a second surface 403 of the example PCB 401. In some examples, the sidewall 405 of the through-hole 404 may be a conductive plating sidewall that extends and/or connects the first surface 402 of the example PCB 401 and the second surface 403 of the example PCB 401.

In some examples, the sidewall 405 of the through-hole 404 may comprise at least one conducting material that is configured to carry an electrical signal to and/or from the compliant pin 300 to the sidewall 405 of the through-hole 404. For example, the at least one conducting material may be copper, aluminum, gold, silver, combinations thereof, and/or the like.

In some examples, the example PCB 401 may be or comprise epoxy, ceramic, alumina, liquid crystalline polymers (LCPs), combinations thereof, and/or the like.

In some embodiments, as the insertion of the example compliant pin 300 into the through-hole 404 of the example PCB 401 starts along a direction of the longitudinal axis 310 of the insertion section 302 (e.g., a z-direction), the first spring 304 may be compressed by the sidewall 405 of the through-hole 404 during the insertion process.

In some embodiments, as the insertion of the example compliant pin 300 into the through-hole 404 of the example PCB 401 further proceeds, the first spring 304 may pass through the through-hole 404 as shown in FIG. 4A.

In some examples, the second spring 305 may stop the insertion of the example compliant pin 300 further into the through-hole 404 of the example PCB 401 in an instance in which the second spring 305 is in contact with the first surface 402 of the example PCB 401. In some examples, the second spring 305 may be configured to determine an insertion depth of the example compliant pin 300.

In some embodiments, the first spring 304 may recover elasticity in an instance in which the first spring 304 passes through the through-hole 404, and thus the first spring 304 may be in contact with the second surface 403 of the example PCB 401.

In some examples, the example PCB 401 is configured to rest between the first spring 304 and the second spring 305, such that the movement of the example PCB 401 in the direction of the longitudinal axis 310 of the insertion section 302 (e.g., the z-direction) is constrained.

In some examples, the plurality of contact splits 306 may be compressed in an axial direction by the sidewall 405 of the through-hole 404 of the example PCB 401 in an instance in which the insertion section 302 is inserted into the through-hole 404 of the example PCB 401, such that the contact portion 303 and the sidewall 405 of the through-hole 404 of the example PCB 401the example PCB 401 may be electrically coupled. For example, the axial direction may be perpendicular to the longitudinal axis 310 of the insertion section 302.

In some examples, an axial holding force between the contact portion 303 and the sidewall 405 of the through-hole 404 of the example PCB 401 may depends on a diameter of the through-hole 404 of the example PCB 401 and a size of the contact portion 303.

In some embodiments, example compliant pin 400 may be used to connect the example PCB 401 with a sensor device (not shown), such that a flatness of PCB may be maintained.

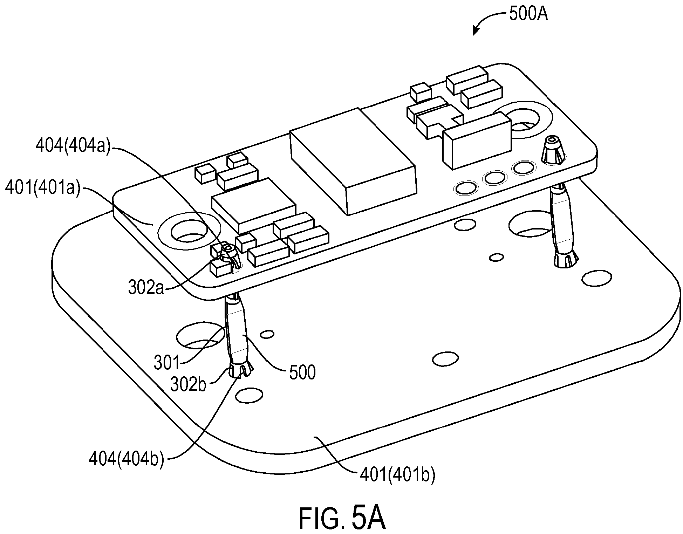

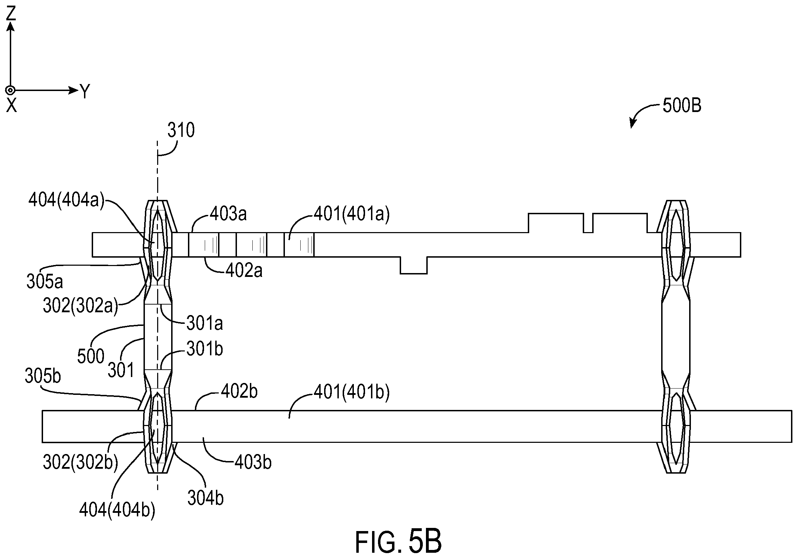

Referring now to FIG. 5A and FIG. 5B, example diagrams illustrating a perspective view 500A and a cross-section 500B view of example compliant pins 500 inserted into example PCBs 401 in accordance with some example embodiments described herein is provided. For example, as shown in FIG. 5A and FIG. 5B, the example compliant pins 500 may be inserted into the example PCBs 401 to provide an electrical connection between the example PCBs 401. In some examples, the example compliant pin 500 may comprise a main section 301, a first insertion section 302a positioned at a first end 301a of the main section 301, and a second insertion section 302b positioned at a second end 301b of the main section 301. For example, the first insertion section 302a and the second insertion section 302b may be attached to the main section 301.

In some embodiments, components of the first insertion section 302a described herein in FIG. 5A and FIG. 5B may correspond to the components of the insertion section 302 as described in FIG. 4A and FIG. 4B. In some examples, components of the second insertion section 302b described herein in FIG. 5A and FIG. 5B may correspond to the components of the insertion section 302 as described in FIG. 4A and FIG. 4B.

In some embodiments, as the insertion of the example compliant pin 500 into the through-hole 404a of an example PCB 401a proceeds, the first spring 304a of the first insertion section 302a may pass through the through-hole 404a of the example PCB 401a.

In some examples, the second spring 305a of the first insertion section 302a may stop the insertion of the example compliant pin 500 further into the through-hole 404a of the example PCB 401a in an instance in which the second spring 305a of the first insertion section 302a is in contact with the first surface 402a of the example PCB 401a. In some examples, the second spring 305a of the first insertion section 302a may be configured to determine a first insertion depth of the example compliant pin 500 into the example PCB 401a.

In some embodiments, the first spring 304a of the first insertion section 302a may recover elasticity in an instance in which the first spring 304a of the first insertion section 302a passes through the through-hole 404a of the example PCB 401a, and thus the first spring 304a of the first insertion section 302a may be in contact with the second surface 403a of the example PCB 401a.

In some examples, the example PCB 401a is configured to rest between the first spring 304a of the first insertion section 302a and the second spring 305a of the first insertion section 302a, such that the movement of the example PCB 401a in the direction of the longitudinal axis 310 of the first insertion section 302a (e.g., the z-direction) is constrained.

In some embodiments, as the insertion of the example compliant pin 500 into the through-hole 404b of an example PCB 401b proceeds, the first spring 304b of the second insertion section 302b may pass through the through-hole 404b of an example PCB 401b.

In some examples, the second spring 305b of the second insertion section 302b may stop the insertion of the example compliant pin 500 further into the through-hole 404b of the example PCB 401b in an instance in which the second spring 305b of the second insertion section 302b is in contact with the first surface 402b of the example PCB 401b. In some examples, the second spring 305b of the second insertion section 302b may be configured to determine a second insertion depth of the example compliant pin 500 into the example PCB 401b.

In some embodiments, the first spring 304b of the second insertion section 302b may recover elasticity in an instance in which the first spring 304b of the second insertion section 302b passes through the through-hole 404b of an example PCB 401b, and thus the first spring 304b of the second insertion section 302b may be in contact with the second surface 403b of the example PCB 401b.

In some examples, the example PCB 401b is configured to rest between the first spring 304b of the second insertion section 302b and the second spring 305b of the second insertion section 302b, such that the movement of the example PCB 401b in the direction of the longitudinal axis 310 of the first insertion section 302a (e.g., the z-direction) is constrained.

In some examples, the example PCB 401a is electrically connected with the example PCB 401b through the example compliant pin 500.

In some embodiments, components of the example PCB 401a described herein in FIG. 5A and FIG. 5B may correspond to the components of the example PCB 401 as described in FIG. 4A and FIG. 4B. In some examples, components of the example PCB 401b described herein in FIG. 5A and FIG. 5B may correspond to the components of the example PCB 401 as described in FIG. 4A and FIG. 4B.

In some embodiments, more than one example compliant pins 500 may be used to connect the example PCB 401a and the example PCB 401b. In some examples, the more than one example compliant pins 500 may be used as a standoff for mechanical support between the example PCB 401a and the example PCB 401b, such that a flatness of a printed circuit board assemble (PCBA) may be maintained.

It is to be understood that the disclosure is not to be limited to the specific embodiments disclosed, and that modifications and other embodiments are intended to be included within the scope of the appended claims. Although specific terms are employed herein, they are used in a generic and descriptive sense only and not for purposes of limitation, unless described otherwise.

## Claims

1. A compliant pin, comprising:
a main section; and
a first insertion section on a first end of the main section and configured to be inserted into a through-hole of a printed circuit board (PCB) to provide an electrical connection between the compliant pin and the PCB, wherein the first insertion section comprises:
a contact portion;
a first spring positioned on a first end of the contact portion, wherein the first spring is configured to be compressed during an insertion process and recover elasticity in an instance in which the first spring passes the through-hole of the PCB; and
a second spring positioned on a second end of the contact portion, wherein in the instance in which the first spring passes the through-hole of the PCB, the second spring is configured to stop the first insertion section, and the first spring and the second spring constrain movement of the PCB.

2. The compliant pin according to claim 1, wherein the first insertion section has a needle eye structure.

3. The compliant pin according to claim 1, wherein:
the second spring is configured to be in contact with a first surface of the PCB and the first spring is configured to be in contact with a second surface of the PCB to constrain the movement of the PCB in the instance in which the first spring passes the through-hole of the PCB.

4. The compliant pin according to claim 1, wherein the contact portion comprises a middle portion that protrudes away from a longitudinal axis of the first insertion section.

5. The compliant pin according to claim 4, wherein the middle portion is configured to be compressed by the through-hole of the PCB in the instance in which the first insertion section passes the through-hole of the PCB.

6. The compliant pin according to claim 5, wherein:
the through-hole of the PCB comprises a conductive plating sidewall, and
the middle portion is configured to be compressed by the conductive plating sidewall to provide the electrical connection between the compliant pin and the PCB.

7. The compliant pin according to claim 6, wherein:
the conductive plating sidewall extends between a first surface of the PCB and a second surface of the PCB.

8. The compliant pin according to claim 1, wherein the first insertion section has a cylindrical structure.

9. The compliant pin according to claim 1, wherein the contact portion comprises a plurality of contact splits distributed around a longitudinal axis of the first insertion section.

10. The compliant pin according to claim 9, wherein the plurality of contact splits are uniformly distributed around the longitudinal axis of the first insertion section.

11. The compliant pin according to claim 9, wherein the contact portion comprises four contact splits uniformly distributed around the longitudinal axis of the first insertion section.

12. The compliant pin according to claim 9, wherein each of the plurality of contact splits comprises a middle portion configured to be compressed by the through-hole of the PCB in the instance in which the first insertion section passes the through-hole of the PCB.

13. The compliant pin according to claim 12, wherein:
the through-hole of the PCB comprises a conductive plating sidewall, and
the middle portion is configured to be compressed by the conductive plating sidewall to provide the electrical connection between the compliant pin and the PCB.

14. The compliant pin according to claim 13, wherein:
the conductive plating sidewall extends between a first surface of the PCB and a second surface of the PCB.

15. The compliant pin according to claim 1, wherein the compliant pin is formed by a stamping process.
